# EUROPEAN PATENT APPLICATION

(11) **EP 4 804 772 A1**
(43) Date of publication of application: **09.09.2026**
(21) Application number: 24879825.8
(22) Date of filing: 18.10.2024
(51) Int. Cl.: H10K 39/10, H10K 30/50, H10K 30/88

(54) **SEALING MATERIAL SHEET FOR SOLAR CELL MODULE, SOLAR CELL MODULE, AND METHOD FOR MANUFACTURING SOLAR CELL MODULE**

(30) Priority: 18.10.2023 JP 2023179284
(71) Applicant: Dai Nippon Printing Co., Ltd., Tokyo 162-8001 (JP)
(72) Inventor: KATO, Shuma, Tokyo 162-8001 (JP); SAEKI, Kosuke, Tokyo 162-8001 (JP); TSUZUKI, Atsuo, Tokyo 162-8001 (JP)
(74) Representative: Beck Greener LLP
(86) International application number: PCT/JP2024/037203
(87) International publication number: WO 2025/084405

(57) **Abstract**

The present disclosure provides a sealing material sheet for a solar cell module comprising, in this order: a first layer including a first olefin based resin, and a melt mass flow rate measured according to JIS K7210-1:2014 at a temperature of 190°C and a load of 2.16 kg is 0.8 g/10 minutes or more; a second layer including a second olefin based resin, and a melt mass flow rate measured according to JIS K7210-1:2014 at a temperature of 190°C and a load of 2.16 kg is 0.4 g/10 minutes or less; and a third layer including a third olefin based resin, and a melt mass flow rate measured according to JIS K7210-1:2014 at a temperature of 190°C and a load of 2.16 kg is 0.8 g/10 minutes or more.

## Description

### Technical Field

The present disclosure relates to a sealing material sheet for a solar cell module and a solar cell module using the same, and a method for producing the same.

### Background Art

In recent years, with growing awareness of environmental issues, solar cells have attracted attention as a clean energy source. Solar cells include conventionally widely used inorganic based solar cells such as silicon solar cells, and organic based solar cells such as dye-sensitized solar cells, organic thin-film solar cells, and perovskite solar cells. Among these, perovskite solar cells are expected to be introduced to the market due to their advantages such as flexibility, ultra-lightweight, high efficiency, and low cost.

Modularization is necessary for practical application. When producing solar cell modules, a lamination process is generally carried out in which a surface member, a sealing material sheet, a solar cell, a sealing material sheet, and a rear surface member are stacked in order, and then heated and pressurized to adhere them together. However, since the heat resistance of perovskite solar cells is low, it is necessary to lower the lamination temperature. For example, in perovskite solar cells, it has been confirmed that the output decreases when Spiro-OMeTAD, which is used as a hole transport material, crystallizes at high temperature. Furthermore, it has been reported that crystallization can be suppressed by asymmetrically altering the structure of the hole transport material described above. (See Patent Document 1)

Meanwhile, in the case of silicon solar cells, the lamination temperature is often set to 150°C or more. Therefore, conventional sealing material sheets are not designed for low-temperature lamination process such as 120°C or less.

### Citation List

### Patent Documents

Patent Document 1: Japanese Patent Application Laid-Open (JP-A) No. 2020-74416
Patent Document 2: WO2011/152314
Patent Document 3: JP-A No. 2014-72300

### Summary of Disclosure

### Technical Problem

To lower the lamination temperature, one approach is, for example, to lower the melting point of the resin included in the sealing material sheet, thereby increasing its fluidity at low temperatures. However, increasing the fluidity of the resin at low temperature reduces the heat resistance of the sealing material sheet. When the heat resistance of the sealing material sheet is insufficient, the long-term durability of the solar cell module is impaired, and the power generation efficiency is reduced.

As sealing material sheets, sealing material sheets including EVA (ethylene-vinyl acetate copolymer), which has excellent transparency and adhesive properties, are widely used. In the sealing material sheet including EVA, heat resistance is imparted by adding a cross-linking agent to the sealing material composition and cross-linking the EVA after shape-forming the sealing material composition. However, when heated enough to accelerate the cross-linking reaction, during the lamination process, the perovskite solar cell will degrade.

In recent years, sealing material sheets including olefin based resin have been developed in place of EVA. Also, in the sealing material sheets including olefin based resins, heat resistance can be imparted by cross-linking the olefin based resin. However, as described above, when heated enough to accelerate the cross-linking reaction, during the lamination process, the perovskite solar cell will degrade. Although it is possible to omit cross-linking of the sealing material sheet including olefin based resin, it is necessary to increase the melting point of the olefin based resin in order to impart heat resistance.

Thus, achieving both low-temperature lamination process and heat resistance simultaneously is difficult.

The present disclosure has been made in view of the above circumstances, and a main object thereof is to provide a sealing material sheet for a solar cell module capable of achieving both low-temperature lamination process and heat resistance simultaneously.

### Solution to Problem

One embodiment of the present disclosure provides a sealing material sheet for a solar cell module comprising, in this order: a first layer including a first olefin based resin, and a melt mass flow rate measured according to JIS K7210-1:2014 at a temperature of 190°C and a load of 2.16 kg is 0.8 g/10 minutes or more; a second layer including a second olefin based resin, and a melt mass flow rate measured according to JIS K7210-1:2014 at a temperature of 190°C and a load of 2.16 kg is 0.4 g/10 minutes or less; and a third layer including a third olefin based resin, and a melt mass flow rate measured according to JIS K7210-1:2014 at a temperature of 190°C and a load of 2.16 kg is 0.8 g/10 minutes or more.

Another embodiment of the present disclosure provides a sealing material sheet for a solar cell module comprising a first surface and a second surface facing the first surface, and including an olefin based resin, wherein when each region obtained by equally dividing the sealing material sheet for a solar cell module into 10 regions in a thickness direction is numbered from a first region to a tenth region, in order from a first surface side toward a second surface side, a melt mass flow rate of the first region, measured according to JIS K7210-1:2014 at a temperature of 190°C and a load of 2.16 kg, is 0.8 g/10 minutes or more; a melt mass flow rate of the fifth region, measured according to JIS K7210-1:2014 at a temperature of 190°C and a load of 2.16 kg, is 0.4 g/10 minutes or less; and a melt mass flow rate of the tenth region, measured according to JIS K7210-1:2014 at a temperature of 190°C and a load of 2.16 kg, is 0.8 g/10 minutes or more.

Another embodiment of the present disclosure provides a sealing material sheet for a solar cell module comprising: a first layer including a first olefin based resin, and a melt mass flow rate measured according to JIS K7210-1:2014 at a temperature of 190°C and a load of 2.16 kg is 0.8 g/10 minutes or more; and a second layer including a second olefin based resin, and a melt mass flow rate measured according to JIS K7210-1:2014 at a temperature of 190°C and a load of 2.16 kg is 0.4 g/10 minutes or less.

Another embodiment of the present disclosure provides a sealing material sheet for a solar cell module comprising a first surface and a second surface facing the first surface, and including an olefin based resin, wherein when each region obtained by equally dividing the sealing material sheet for a solar cell module into 10 regions in a thickness direction is numbered from a first region to a tenth region, in order from a first surface side toward a second surface side, a melt mass flow rate of the first region, measured according to JIS K7210-1:2014 at a temperature of 190°C and a load of 2.16 kg, is 0.8 g/10 minutes or more; and a melt mass flow rate of the tenth region, measured according to JIS K7210-1:2014 at a temperature of 190°C and a load of 2.16 kg, is 0.4 g/10 minutes or less.

Another embodiment of the present disclosure provides a solar cell module comprising a solar cell; and the sealing material sheet for a solar cell module described above.

Another embodiment of the present disclosure provides a method for producing a solar cell module, the method comprising a lamination step of heating and pressurizing a stacked body including a solar cell and the sealing material sheet for a solar cell module described above, wherein, a heating temperature in the lamination step is 60°C or more and 120°C or less.

### Advantageous Effects of Disclosure

The sealing material sheet for a solar cell module in the present disclosure exhibits effects that it is capable of achieving both low-temperature lamination process and heat resistance simultaneously.

### Brief Description of Drawings

[FIG. 1] is a schematic cross-sectional view exemplifying a sealing material sheet for a solar cell module in the present disclosure.
[FIG. 2] is a schematic cross-sectional view exemplifying a sealing material sheet for a solar cell module in the present disclosure.
[FIG. 3] is a schematic cross-sectional view exemplifying a sealing material sheet for a solar cell module in the present disclosure.
[FIG. 4] is a schematic cross-sectional view exemplifying a solar cell module in the present disclosure.
[FIG. 5] is a schematic cross-sectional view exemplifying a solar cell module in the present disclosure.
[FIG. 6] is a schematic cross-sectional view exemplifying a solar cell module in the present disclosure.
[FIG. 7] is a schematic cross-sectional view exemplifying a solar cell module in the present disclosure.
[FIG. 8] is a schematic cross-sectional view exemplifying a solar cell module in the present disclosure.
[FIG. 9] is a schematic cross-sectional view exemplifying a solar cell module in the present disclosure.
[FIG. 10] is a schematic cross-sectional view exemplifying a solar cell module in the present disclosure.

### Description of Embodiments

Embodiments in the present disclosure are hereinafter explained with reference to, for example, drawings. However, the present disclosure is implemented in a variety of different forms, and thus should not be taken as is limited to the contents described in the embodiments exemplified as below. Also, the drawings may show the features of the present disclosure such as width, thickness, and shape of each part schematically comparing to the actual form in order to explain the present disclosure more clearly in some cases; however, it is merely an example, and thus does not limit the interpretation of the present disclosure. Also, in the present descriptions and each drawing, for the factor same as that described in the figure already explained, the same reference sign is indicated and the detailed explanation thereof may be omitted.

In the present descriptions, on the occasion of expressing an aspect wherein some member is disposed on the other member, when described as merely "on" or "below", unless otherwise stated, it includes both of the following cases: a case wherein some member is disposed directly on or directly below the other member so as to be in contact with the other member, and a case wherein some member is disposed on the upper side or the lower side of the other member via yet another member. Also, in the present descriptions, on the occasion of expressing an aspect wherein some member is disposed on the surface of the other member, when described as merely "on the surface", unless otherwise stated, it includes both of the following cases: a case wherein some member is disposed directly on or directly below the other member so as to be in contact with the other member, and a case wherein some member is disposed on the upper side or the lower side of the other member via yet another member.

Also, in the present descriptions, a member referred to as "film" is included in "sheet". Also, a member referred to as "sheet" is included in "film".

The sealing material sheet for a solar cell module, a solar cell module and a method for producing a solar cell module in the present disclosure are hereinafter described in detail.

### A. Sealing material sheet for solar cell module

The sealing material sheet for a solar cell module in the present disclosure includes four embodiments. Each embodiment is hereinafter described.

### I. First embodiment of sealing material sheet for solar cell module

The first embodiment of the sealing material sheet for a solar cell module in the present disclosure comprises, in this order: a first layer including a first olefin based resin, and a melt mass flow rate measured according to JIS K7210-1:2014 at a temperature of 190°C and a load of 2.16 kg is 0.8 g/10 minutes or more; a second layer including a second olefin based resin, and a melt mass flow rate measured according to JIS K7210-1:2014 at a temperature of 190°C and a load of 2.16 kg is 0.4 g/10 minutes or less; and a third layer including a third olefin based resin, and a melt mass flow rate measured according to JIS K7210-1:2014 at a temperature of 190°C and a load of 2.16 kg is 0.8 g/10 minutes or more.

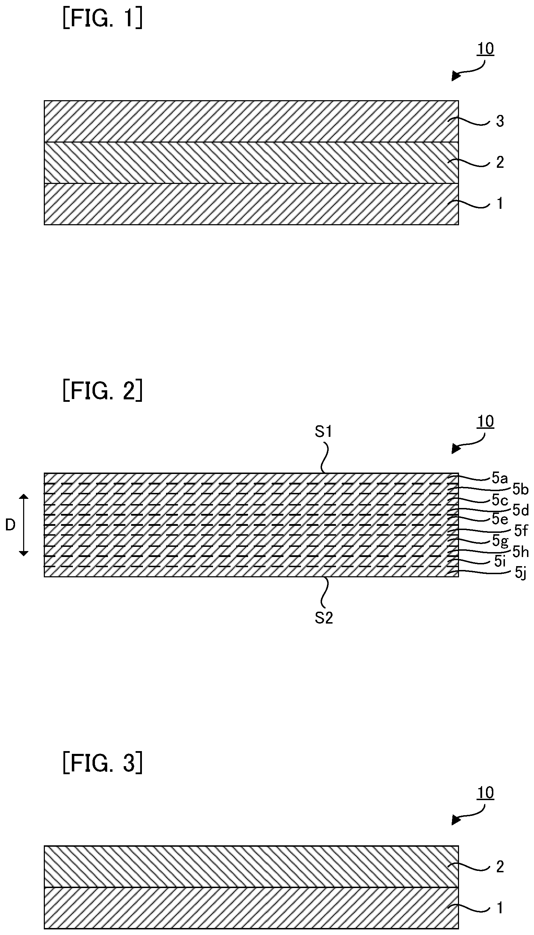

FIG. 1 is a schematic cross-sectional view exemplifying a sealing material sheet for a solar cell module in the present embodiment. As shown in FIG. 1, the sealing material sheet for a solar cell module 10 includes, in this order, a first layer 1 including a first olefin based resin, and the melt mass flow rate is in a predetermined range; a second layer 2 including a second olefin based resin, and the melt mass flow rate is in a predetermined range; and a third layer 3 including a third olefin based resin, and the melt mass flow rate is in a predetermined range.

According to the present embodiment, since the melt mass flow rate of the first layer and the melt mass flow rate of the third layer are a predetermined value or more, the fluidity at low temperature is high so that the adhesion between the sealing material sheet for a solar cell module and other members can be improved, and low-temperature lamination process is possible in the production of a solar cell module using the sealing material sheet for a solar cell module. Also, since the flexibility at low temperature is high, it is possible to suppress the cracking of the solar cell during lamination process. Furthermore, it is possible to improve the embedding properties and convexoconcave following capability of the solar cell during the lamination process. Also, according to the present embodiment, since the melt mass flow rate of the second layer is a predetermined value or less, the fluidity during heating is low so that the heat resistance of the sealing material sheet for a solar cell module can be improved. Therefore, in the present embodiment, it is possible to achieve both low-temperature lamination process and heat resistance simultaneously. Therefore, the sealing material sheet for a solar cell module in the present embodiment is preferable for the solar cell module using a perovskite solar cell.

Incidentally, in the case of conventionally widely used silicon solar cells, the lamination temperature is often set to 150°C or higher. In conventional lamination process at temperature of 150°C or more, when the melt mass flow rate of the sealing material sheet is increased, the fluidity during heating may be excessively high. Therefore, handling may be difficult. Also, the thickness of the sealing material sheet may not be maintained during lamination process, which may impair the ability to protect the solar cell from an impact. Therefore, in conventional lamination process, it was not considered possible to set the melt mass flow rate to a predetermined value or more, such as the first layer and third layer in the present embodiment. In contrast to this, in the present embodiment, it is possible to achieve both low-temperature lamination process and heat resistance simultaneously, since the melt mass flow rate of the first layer and the melt mass flow rate of the third layer are a predetermined value or more and the melt mass flow rate of the second layer is a predetermined value or less.

Hereinafter, the sealing material sheet for a solar cell module in the present embodiment will be described for each configuration.

### 1. First layer

The first layer in the present embodiment includes a first olefin based resin, and the melt mass flow rate measured according to JIS K7210-1:2014 at a temperature of 190°C and a load of 2.16 kg is 0.8 g/10 minutes or more. Incidentally, in the present descriptions, "melt mass flow rate" may be abbreviated simply as "MFR".

### (1) Properties of first layer

### (a) MFR

The MFR of the first layer is 0.8 g/10 minutes or more, preferably 1.7 g/10 minutes or more, and more preferably 2.0 g/10 minutes or more. Since the fluidity at low temperature is high when the MFR of the first layer is in the above range, the adhesion between the first layer of the sealing material sheet for a solar cell module and other members can be improved, and low-temperature lamination process is possible in the production of a solar cell module using the sealing material sheet for a solar cell module. Also, since the flexibility at low temperature is high, it is possible to suppress the cracking of the solar cell during lamination process. Furthermore, when the MFR of the first layer is high among the above range, it is possible to increase the embedding properties and convexoconcave following capability of the solar cell during lamination process. Therefore, in the solar cell module, the penetration of moisture and oxygen into the interface between the first layer of the sealing material sheet for a solar cell module and the solar cell can be suppressed. Meanwhile, the MFR of the first layer is, for example, 10 g/10 minutes or less, may be 9 g/10 minutes or less, and may be 8 g/10 minutes or less. When the MFR of the first layer is too high, the heat resistance of the sealing material sheet for a solar cell module may decrease. Also, when the MFR of the first layer is too high, the sealing material sheet for a solar cell module may easily protrude during lamination process. Specifically, the MFR of the first layer is preferably 0.8 g/10 minutes or more and 10 g/10 minutes or less, more preferably 1.7 g/10 minutes or more and 9 g/10 minutes or less, and further preferably 2.0 g/10 minutes or more and 8 g/10 minutes or less.

Here, the MFR of the first layer is measured according to Method A in JIS K7210-1:2014 at a temperature of 190°C and a load of 2.16 kg.

Incidentally, in the sealing material sheet for a solar cell module, it is sometimes difficult to distinguish the interface between the first layer, the second layer and the third layer. For example, when the density of the olefin based resin included in each layer is close to each other, it is difficult to distinguish the interface between each layer. In such a case, in a sealing material sheet for a solar cell module including a first surface and a second surface facing the first surface, each region obtained by equally dividing the sealing material sheet for a solar cell module into 10 regions in the thickness direction is numbered from a first region to a tenth region, in order from the first surface side toward the second surface side. Then, the MFR of the first region is measured, and the MFR of the first region is regarded as the MFR of the first layer. Also, in this case, the MFR of the tenth region is regarded as the MFR of the third layer. Also, the MFR of the region where the MFR thereof is different from the MFR of the first region and the MFR of the tenth region, for example, the fifth region is regarded as the MFR of the second layer. When equally dividing the sealing material sheet for a solar cell module in the thickness direction, the sealing material sheet for a solar cell module may be sliced using, for example, a microtome.

When the first layer is obtained by shape forming a first layer composition, for example, examples of the method for adjusting the MFR of the first layer may include a method using a first layer composition whose MFR is in the above range; and a method wherein the resin is cross-linked during shape forming of the first layer composition. Examples of the method for adjusting the MFR of the first layer composition may include a method adjusting the MFR of the resin included in the first layer composition. Also, in the case of a method wherein the resin is cross-linked during the shape forming of the first layer composition, by adding less cross-linking agent than conventionally general cross-linking process, it is possible to realize a condition in which the degree of cross-linking is low and the molecular weight is high, by heating during the shape forming of the first layer composition. Hereafter, this condition may be referred to as a weak cross-linking. This allows for easy adjustment of the MFR of the first layer to fall in the above range. Also, since the weak cross-linking reaction proceeds during the shape forming of the first layer composition, there is no need to cross-link the resin in the lamination process in the production of a solar cell module using the sealing material sheet for a solar cell module. Therefore, there is no need to increase the lamination temperature for the cross-linking reaction, and it is suitable for low-temperature lamination process.

### (b) Gel fraction

The gel fraction of the first layer is preferably 25% or less, more preferably 20% or less, and further preferably 18% or less. The gel fraction of the first layer may be 0%. By the weak cross-linking, only the molecular weight can be increased without generating gels that interfere with film formation. When the gel fraction is in the above range, film forming ability can be maintained. Incidentally, a feature of the weak cross-linking is that, since the cross-linking reaction proceeds during shape forming, and hardly any cross-linking reaction occurs during lamination process, the change in the gel fraction before and after the lamination process is low.

Here, in the present descriptions, the gel fraction (%) is a value obtained by the following method. First, 1.0 g of a sample is placed in an 80-mesh wire mesh bag. Then, the wire mesh is inserted into a soxhlet extractor, and xylene is refluxed at its boiling point. After continuous extraction for 10 hours, the sample is removed along with the wire mesh, dried, and then weighed. The mass comparison before and after the extraction is carried out, and the % by mass of the residual insoluble content is measured. This is referred to as the gel fraction.

Incidentally, the gel fraction being 0% means that the residual insoluble content is substantially zero, and the cross-linking reaction of the first layer composition has not started substantially. More specifically, the gel fraction being 0% means that there is no residual insoluble content at all or that the % by mass of the residual insoluble content measured by precision balance is less than 0.05% by mass.

Also, the residual insoluble content does not include pigment components other than resin components. When the mixture other than these resin components is mixed in the residual insoluble content as a result of the test, the gel fraction that should be obtained for the residual insoluble content derived from the resin component excluding these mixtures is calculated by separately measuring the content of these mixtures in the resin component in advance.

Incidentally, as described above, in the sealing material sheet for a solar cell module, it is sometimes difficult to distinguish the interface between the first layer, the second layer and the third layer. In such a case, in a sealing material sheet for a solar cell module including a first surface and a second surface facing the first surface, each region obtained by equally dividing the sealing material sheet for a solar cell module into 10 regions in the thickness direction is numbered from a first region to a tenth region, in order from the first surface side toward the second surface side. Then, the gel fraction of the first region is measured, and the gel fraction of the first region is regarded as the gel fraction of the first layer. Also, in this case, the gel fraction of the tenth region is regarded as the gel fraction of the third layer. Also, the gel fraction of the region where the MFR thereof is different from the MFR of the first region and the MFR of the tenth region, for example, the fifth region is regarded as the gel fraction of the second layer.

### (c) Weight-average molecular weight

As described above, by the weak cross-linking, only the molecular weight can be increased without generating gels that interfere with film formation. The weight-average molecular weight of the first layer is preferably, for example, 120,000 or more, and 300,000 or less.

Here, the weight-average molecular weight is a value in terms of polystyrene when measured with a high-temperature gel permeation chromatography (GPC) method. For a measurement device, SSC-7120 from Senshu Science Company is used, two HT-806M from Showa Denko K.K. are used as the columns, and o-dichlorobenzene is used as the solvent. The flow rate is 1 mL/min and the column temperature is 145°C.

Incidentally, as described above, in the sealing material sheet for a solar cell module, it is sometimes difficult to distinguish the interface between the first layer, the second layer and the third layer. In such a case, in a sealing material sheet for a solar cell module including a first surface and a second surface facing the first surface, each region obtained by equally dividing the sealing material sheet for a solar cell module into 10 regions in the thickness direction is numbered from a first region to a tenth region, in order from the first surface side toward the second surface side. Then, the weight-average molecular weight of the first region is measured, and the weight-average molecular weight of the first region is regarded as the weight-average molecular weight of the first layer. Also, in this case, the weight-average molecular weight of the tenth region is regarded as the weight-average molecular weight of the third layer. Also, the weight-average molecular weight of the region where the MFR thereof is different from the MFR of the first region and the MFR of the tenth region, for example, the fifth region is regarded as the weight-average molecular weight of the second layer.

### (2) Material of first layer

The first layer in the present embodiment includes a first olefin based resin.

### (a) First olefin based resin

Examples of the first olefin based resin may include polyethylene based resins, polypropylene based resins, and polybutadiene based resins. Also, as the first olefin based resin, an olefin based elastomer of a blend type of a polyethylene based resin or polypropylene based resin with a rubber component may be used. Among them, polyethylene based resins are preferable.

The polyethylene based resin may be a monopolymer of ethylene, may be a copolymer of ethylene and α-olefin.

Examples of the polyethylene based resin may include high density polyethylenes (HDPE), low density polyethylenes (LDPE), linear low density polyethylenes (LLDPE), metallocene based linear low density polyethylenes (M-LLDPE), and very low density polyethylenes (VLDPE). One type of the polyethylene based resin may be used alone, and two types or more may be used in a combination.

Among them, low density polyethylenes, linear low density polyethylenes, metallocene based linear low density polyethylenes, and very low density polyethylenes are preferable. They have good flexibility, transparency and shape forming processability.

Particularly, metallocene based linear low-density polyethylene is preferable. The metallocene based linear low density polyethylene is synthesized using a metallocene catalyst that is a single-site catalyst. In such polyethylene, there is little branching of side chains and the distribution of comonomers is uniform. Therefore, the molecular weight distribution is narrow, and it is possible to reduce the density as described later. Also, since the crystallinity distribution is narrow and the crystal size is uniform, not only are there no large crystals, but the crystallinity itself is low due to the low density. Therefore, it is highly transparent.

When the polyethylene based resin is a copolymer of ethylene and α-olefin, an α-olefin without branching is preferable as the α-olefin. Among them, an α-olefin having a carbon number of 3 or more and 8 or less is preferable, and an α-olefin having a carbon number of 6 or more and 8 or less is more preferable. Examples thereof may include 1-hexene, 1-heptene, and 1-octene. When the α-olefin has a carbon number of 3 or more and 8 or less, good flexibility as well as good strength can be imparted to the first layer. Therefore, the adhesion between the first layer and the solar cell is improved so that the penetration of moisture into the interface between the first layer of the sealing material sheet for a solar cell module and the solar cell can be suppressed. The α-olefin in the copolymer of ethylene and α-olefin may be one type, and may be two types or more. Also, one type of the copolymer of ethylene and α-olefin may be used alone, and two types or more may be used in a combination.

The density of the polyethylene based resin is preferably, for example, 0.920 g/cm³ or less, more preferably 0.870 g/cm³ or more and 0.920 g/cm³ or less, and further preferably 0.870 g/cm³ or more and 0.910 g/cm³ or less. When the density of polyethylene based resin is in the above range, the flexibility, transparency, and shape forming processability can be improved.

Here, the density of the polyethylene based resin is measured by a method B (pycnometry method) according to JIS K7112:1999.

When the first olefin based resin is the polyethylene based resin, the melting point of the polyethylene based resin is preferably 50°C or more, and more preferably 55°C or more. Meanwhile, the melting point of the polyethylene based resin is preferably 100°C or less, and more preferably 95°C or less. That is, the melting point of the polyethylene based resin is preferably 50°C or more and 100°C or less, and more preferably 55°C or more and 95°C or less. When the melting point is in the above range, low-temperature lamination process is possible in the production of a solar cell module using the sealing material sheet for a solar cell module. Also, when the melting point is too low, the heat resistance may be insufficient. Also, when the melting point is too high, the crystallinity degradation when used as a solar cell module is insufficient, and the transparency may decrease.

Here, in the present specification, the melting point of the resin is measured by differential scanning calorimetry (DSC) in accordance with the plastic transition temperature measuring method in JIS K7121:2012. Incidentally, when the first layer composition includes a plurality of resins, there may be two or more melting peaks in the DSC curve. In this case, the temperature of the melting peak with the highest endothermic amount is regarded as the melting point of the first olefin based resin. This is because the first layer includes the first olefin based resin as a base resin. Incidentally, "base resin" refers to the resin with the highest content ratio in each layer.

The content of the first olefin based resin, with respect to 100 parts by mass of all the resin components included in the first layer, is preferably, for example, 50 parts by mass or more, more preferably 55 parts by mass or more, and further preferably 60 parts by mass or more. When the content of the first olefin based resin is in the above range, transparency and flexibility can be improved.

As described above, in the first layer, the first olefin based resin may not be cross-linked, and at least a part of the first olefin based resin may be cross-linked.

### (b) Silane component

The first layer may include a silane component. By including the silane component, the adhesion between the first layer and the solar cell can be improved.

Examples of the silane component may include silane coupling agents and silane-modified polyolefin based resins.

### (i) Silane coupling agent

As the silane coupling agent, a silane coupling agent commonly used for sealing material sheets for a solar cell module can be used. One type of the silane coupling agent may be used alone, and two types or more may be used in a combination.

The content of the silane coupling agent in the first layer is, for example, 0.05% by mass or more, may be 0.1% by mass or more, and may be 0.15% by mass or more. Meanwhile, the content of the silane coupling agent in the first layer is, for example, 15% by mass or less, may be 5% by mass or less, and may be 2% by mass or less. That is, the content of the silane coupling agent in the first layer is, for example, 0.05% by mass or more and 15% by mass or less, may be 0.1% by mass or more and 5% by mass or less, and may be 0.15% by mass or more and 2% by mass or less. When the content of the silane coupling agent is too low, the adhesiveness improving effect due to the silane coupling agent may not be sufficiently obtained. Meanwhile, when the content of the silane coupling agent is too high, film-forming ability may decrease, or the silane coupling agent may bleed out.

### (ii) Silane-modified polyolefin based resin

The silane-modified polyolefin based resin is a copolymer of α-olefin and ethylenically unsaturated silane compound. By including the silane-modified polyolefin based resin, a solar cell module that can be applied to various use application and having the following properties can be produced stably at low cost: excellent in strength and durability, for example; excellent in weather resistance, heat resistance, water resistance, light resistance, wind pressure resistance, hail-falling resistance and various other characteristics; and further, exhibits outstanding heat fusion property, not being affected by production conditions such as heat compression bonding at the time of producing the solar cell module.

The silane-modified polyolefin based resin is a copolymer obtained by copolymerizing α-olefin and ethylenically unsaturated silane compound, and if necessary, other monomers. The silane-modified polyolefin based resins also include modified products or condensation products of the above copolymers.

Examples of the α-olefin may include ethylene, propylene, 1-butene, isobutylene, 1-pentene, 2-methyl-1-butene, 3-methyl-1-butene, 1-hexene, 1-heptene, 1-octene, 1-nonene, and 1-decene. One type of the α-olefin may be used alone, and two types or more may be used in a combination. Among them, ethylene is preferable. That is, the silane-modified polyolefin based resin is preferably a silane-modified polyethylene based resin. This is because, when the first olefin based resin is the polyethylene based resin, the polyethylene based resins and silane-modified polyethylene resins are highly compatible.

Examples of the ethylenically unsaturated silane compound may include vinyltrimethoxysilane, vinyltriethoxysilane, vinyltripropoxysilane, vinyltriisopropoxysilane, vinyltributoxysilane, vinyltripentyloxysilane, vinyltriphenoxysilane, vinyltribenzyloxysilane, vinyltrimethylenedioxysilane, vinyltriethylenedioxysilane, vinylpropionyloxysilane, vinyltriacetoxysilane, and vinyltricarboxysilane. One type of the ethylenically unsaturated silane compound may be used alone, and two types or more may be used in a combination.

Examples of the other monomer may include vinyl acetate, acrylic acid, methacrylic acid, methyl acrylate, methyl methacrylate, ethyl acrylate, and vinyl alcohol. One type of the other monomer may be used alone, and two types or more may be used in a combination.

The silane-modified polyolefin based resin may be any one of random copolymers, alternating copolymers, block copolymers, and graft copolymers. Among them, a graft copolymer is preferable, and a graft copolymer obtained by polymerizing a polyolefin as a main chain, and an ethylenically unsaturated silane compound as a side chain is more preferable. Since degree of freedom, of a silanol group contributing to adhesiveness, of such graft copolymer is high, adhesiveness of the first layer with respect to the solar cell may be further improved.

One type of the silane-modified polyolefin based resin may be used alone, and two types or more may be used in a combination.

The silane-modified polyolefin based resin may be obtained, for example, by the method for producing described in Japanese Patent Application Laid-Open (JP-A) No. 2003-46105.

The content of the silane-modified polyolefin based resin in the first layer is, for example, 1% by mass or more, may be 3% by mass or more, and may be 5% by mass or more. Meanwhile, the content of the silane-modified polyolefin based resin in the first layer is, for example, 20% by mass or less, may be 18% by mass or less, and may be 15% by mass or less. That is, the content of the silane-modified polyolefin based resin in the first layer is, for example, 1% by mass or more and 20% by mass or less, may be 3% by mass or more and 18% by mass or less, and may be 5% by mass or more and 15% by mass or less. When the content of the silane-modified polyolefin based resin is too low, the adhesiveness improving effect due to the silane-modified polyolefin based resin may not be sufficiently obtained. Meanwhile when the content of the silane-modified polyolefin based resin is too high, it tends to have poor in tensile elongation and heat-welding properties.

### (c) Cross-linking agent

When the first layer is obtained by shape forming a first layer composition, the first layer composition may include a cross-linking agent.

In the present disclosure, the content of the cross-linking agent is reduced compared to that in the conventional general cross-linking treatments. The content of the cross-linking agent in the first layer composition is preferably less than 0.5% by mass, more preferably 0.2% by mass or less, and further preferably 0.1% by mass or less. When the content of the cross-linking agent in the first layer composition is too high, gel formation may occur during the shape forming of the first layer composition, potentially leading to reduced film forming ability or decreased transparency. Meanwhile the content of cross-linking agent in the first layer composition may be 0% by mass, and may be 0.001% by mass or more.

The cross-linking agent is not particularly limited, and commonly known cross-linking agent can be used. For example, a known radical polymerization initiator may be used. Examples of the radical polymerization initiator may include organic peroxides, azo compounds, and silanol condensation catalysts. Examples of the organic peroxide may include hydroperoxides, dialkylperoxides, diacylperoxides, peroxyesters, ketoneperoxides, and peroxycarbonates. Examples of the hydroperoxides may include diisopropylbenzene hydroperoxide and 2,5-dimethyl-2,5-di(hydroperoxy)hexane. Examples of the dialkylperoxides may include di-t-butylperoxide, t-butylcumylperoxide, dicumylperoxide, 2,5-dimethyl-2,5-di(t-butylperoxy)hexane, and 2,5-dimethyl-2,5-di(t-peroxy)hexine-3. Examples of the diacyl peroxides may include bis-3,5,5-trimethylhexanoyl peroxide, octanoyl peroxide, benzoyl peroxide, o-methylbenzoyl peroxide, and 2,4-dichlorobenzoyl peroxide. Examples of the peroxyesters may include t-butyl peroxyacetate, t-butyl t-ethylhexanoate, t-butyl peroxypivalate, t-butyl peroxyoctoate, t-butyl peroxyisopropyl carbonate, t-butyl peroxybenzoate, di-t-butyl peroxyphthalate, 2,5-dimethyl-2,5-di(benzoylperoxy)hexane, 2,5-dimethyl-2,5-di(benzoylperoxy)hexine-3, and t-butyl peroxy-2-ethylhexyl carbonate. Examples of the ketone peroxides may include methyl ethyl ketone peroxide and cyclohexanone peroxide. Examples of the peroxycarbonates may include t-amyl-peroxy-2-ethylhexyl carbonate and t-butylperoxy-2-ethylhexyl carbonate. Examples of the azo compound may include azobisisobutyronitrile and azobis(2,4-dimethylvaleronitrile). Examples of the silanol condensation catalyst may include dibutyltin diacetate, dibutyltin dilaurate, dibutyltin dioctoate, dioctyltin dilaurate, and dicumyl peroxide. One type of the cross-linking agent may be used alone, and two types or more may be mixed and used.

Among them, t-butyl peroxy-2-ethylhexyl carbonate and 2,5-dimethyl-2,5-di(t-butylperoxy)hexane are preferable. These have high levels of reactive oxygen content of 5% or more. Also, the one-minute half-life period temperature of these cross-linking agents are 160°C to 190°C and they are consumed at the time of shape forming of the first layer composition. Therefore, they can be suppressed from remaining after the shape forming so that unnecessary post-cross-linking can be suppressed. Incidentally, when the one-minute half-life period temperature is too low, it may be difficult to sufficiently disperse the cross-linking agent during the shape forming of the first layer composition, and then, progressing the cross-linking reaction.

A cross-linking agent masterbatch may also be used as the cross-linking agent. The cross-linking agent masterbatch is a mixture in which a cross-linking agent is dispersed in a resin. The cross-linking agent masterbatch may be appropriately prepared and used as needed, and a commercially available product may be used. The resin used for the cross-linking agent masterbatch may be the first olefin based resin, and may be other resins.

When the first layer is obtained by shape forming a first layer composition, as described later, the preferable shape forming temperature is equal to or more than the one-minute half-life period temperature of the cross-linking agent, so that almost no cross-linking agent remains in the first layer after shape forming. That is, the first layer is substantially free of cross-linking agents. In the present specification, "substantially free of cross-linking agents" includes cases where an extremely small amount of cross-linking agents remain as impurities, but are not sufficient to cause a cross-linking reaction. Specifically, "substantially free of cross-linking agents" means that the cross-linking agent content in the first layer is less than 0.00001% by mass.

### (d) Cross-linking assistant

When the first layer is obtained by shape forming a first layer composition, the first layer composition may include a cross-linking assistant. Among the above, it is preferable that the first layer composition is substantially free of cross-linking assistants. By not adding a cross-linking assistant, it is possible to realize a state in which the degree of cross-linking is low and the molecular weight is increased. Furthermore, by heating during shape forming, this weak cross-linking reaction can proceed while maintaining film forming ability.

Incidentally, in the present specification, "substantially free of cross-linking assistants" includes cases where an extremely small amount of cross-linking assistants are included as impurities, but are not sufficient to have influence on a cross-linking reaction. Specifically, "substantially free of cross-linking assistants" means that the cross-linking assistant content in the first layer composition is less than 0.00001% by mass.

As the cross-linking assistant, for example, polyfunctional vinyl based monomers and polyfunctional epoxy based monomers can be used. Specific examples may include polyallyl compounds, poly(meth)acryloxy compounds, and epoxy based compounds. Examples of the polyallyl compounds may include triallyl isocyanurate (TAIC), triallyl cyanurate, diallyl phthalate, diallyl fumarate, and diallyl maleate. Examples of the poly(meth) acryloxy compounds may include trimethylolpropane trimethacrylate (TMPT), trimethylolpropane triacrylate (TMPTA), ethylene glycol diacrylate, ethylene glycol dimethacrylate, 1,4-butanediol diacrylate, 1,6-hexanediol diacrylate, and 1,9-nonanediol diacrylate. Examples of the epoxy based compounds may include those including a double bond and an epoxy group such as glycidyl methacrylate, 4-hydroxybutyl acrylate glycidyl ether; and those including two or more epoxy groups such as 1,6-hexanediol diglycidyl ether, 1,4-butanediol diglycidyl ether, cyclohexane dimethanol diglycidyl ether, and trimethylol propane polyglycidyl ether. One type of the cross-linking assistant may be used alone, and two types or more may be mixed and used.

### (e) Other components

The first layer composition may further include other components. Examples may include weather resistant agents and fillers. Examples of the weather resistant agent may include light stabilizers, ultraviolet absorbers, antioxidants, heat stabilizers. The inclusion of these additives provides stable mechanical strength over a long term and suppresses yellowing, cracking, and other issues. Examples of ultraviolet absorber may include benzotriazole based, benzophenone based, triazine based, benzoxazinon based, benzoyl based, benzoate based, oxybenzone based, salicylic acid based, sulfonic acid based, zinc oxide, and titanium oxide. Examples of antioxidant may include phenolic based, phosphorus based, phosphorus-phenolic based, phosphite based, thioether based, and ascorbic acid based. One type of these may be used alone, and two types or more may be mixed and used. The content of these elements varies depending on, for example, the particle shape and density, and it is preferably 0.001% by mass or more and 5% by mass or less in the first layer composition.

A weather resistant agent masterbatch may also be used as the weather resistant agent. The weather resistant agent masterbatch is a mixture in which a weather resistant agent is dispersed in a resin. By adding a weather resistant agent masterbatch to the first layer composition, good weather resistance can be imparted to the first layer. The weather resistant agent masterbatch may be prepared and used as needed, and a commercially available product may be used. The resin used for the weather resistant agent masterbatch may be the first olefin based resin, and may be another resin.

Examples of the further component may include nucleating agents, dispersants, leveling agents, plasticizers, defoaming agents, and flame retardants.

### 2. Second layer

The second layer in the present embodiment includes a second olefin based resin, and a melt mass flow rate measured according to JIS K7210-1:2014 at a temperature of 190°C and a load of 2.16 kg is 0.4 g/10 minutes or less.

### (2) Properties of second layer

### (a) MFR

The MFR of the second layer is 0.4 g/10 minutes or less, preferably 0.35 g/10 minutes or less, and more preferably 0.3 g/10 minutes or less. When the MFR of the second layer is in the above range, the fluidity during heating is low so that the heat resistance of the sealing material sheet for a solar cell module can be improved. Meanwhile, the MFR of the second layer is, for example, 0.01 g/10 minutes or more, may be 0.02 g/10 minutes or more, and may be 0.03 g/10 minutes or more. When the MFR of the second layer is in the above range, good shape forming properties can be obtained. Specifically, the MFR of the second layer is preferably 0.01 g/10 minutes or more and 0.4 g/10 minutes or less, more preferably 0.02 g/10 minutes or more and 0.35 g/10 minutes or less, and further preferably 0.03 g/10 minutes or more and 0.3 g/10 minutes or less. The method for measuring the MFR of the second layer is similar to the method for measuring the MFR of the first layer.

The method for adjusting the MFR of the second layer is similar to the method for adjusting the MFR of the first layer.

### (b) Gel fraction

The gel fraction of the second layer is similar to the gel fraction of the first layer described above.

The difference between the gel fraction of the first layer and the gel fraction of the second layer is preferably, for example 25% or less, more preferably 20% or less, and further preferably 15% or less. Also, the difference of the gel fraction is preferably, for example, 0% or more, more preferably 1% or more, and further preferably 2% or more. That is, the difference of the gel fraction is preferably, for example, 0% or more and 25% or less, more preferably 1% or more and 20% or less, and further preferably 2% or more and 15% or less.

### (c) Weight-average molecular weight

The weight-average molecular weight of the second layer is similar to the weight-average molecular weight of the first layer described above.

### (2) Material of second layer

The second layer in the present embodiment includes a second olefin based resin.

### (a) Second olefin based resin

The type, properties and content of the second olefin based resin are similar to those of the first olefin based resin used for the first layer above. The second olefin based resin used for the second layer may be the same or different from the first olefin based resin used for the first layer described above.

As described above, in the second layer, the second olefin based resin may not be cross-linked, and at least a part of the second olefin based resin may be cross-linked. Among the above, at least a part of the second olefin based resin is preferably cross-linked. The reason therefor is to improve the heat resistance of the sealing material sheet for a solar cell module.

### (b) Silane components

The second layer may include a silane component. By including the silane content, the adhesion between the second layer and the first layer, and adhesion between the second layer and the third layer can be improved.

The silane component is similar to the silane component used for the first layer described above. The silane component used for the second layer may be the same or different from the silane component used for the first layer described above.

### (c) Cross-linking agent

When the second layer is obtained by shape forming a second layer composition, the second layer composition preferably includes a cross-linking agent. The heat resistance of the sealing material sheet for a solar cell module can be improved by applying a weak cross-linking treatment during the shape forming of the second layer composition to cross-link at least a part of the second olefin based resin.

In the present disclosure, as described above, the content of the cross-linking agent is reduced compared to that in the conventional general cross-linking treatments. The content of the cross-linking agent in the second layer composition is preferably less than 0.5% by mass, more preferably 0.2% by mass or less, and further preferably 0.1% by mass or less. When the content of the cross-linking agent in the second layer composition is too high, gel formation may occur during the shape forming of the second layer composition, potentially leading to reduced film forming ability or decreased transparency. Meanwhile the content of cross-linking agent in the second layer composition is preferably, for example, 0.01% by mass or more. When the content of cross-linking agent in the second layer composition is too low, the weak cross-linking of the second olefin based resin may not proceed and the heat resistance may be insufficient.

The type of the cross-linking agent is similar to the cross-linking agent used for the first layer described above.

When the second layer is obtained by shape forming a second layer composition, as described later, the preferable shape forming temperature is equal to or more than the one-minute half-life period temperature of the cross-linking agent, so that almost no cross-linking agent remains in the second layer after shape forming. That is, the second layer is substantially free of cross-linking agents.

### (d) Cross-linking assistant

When the second layer is obtained by shape forming a second layer composition, the second layer composition may include a cross-linking assistant. Among the above, it is preferable that the second layer composition is substantially free of cross-linking assistants.

The type of the cross-linking assistant is similar to the cross-linking assistant used for the first layer described above.

### (e) Other components

The second layer composition may further include other components. The other components are similar to the other components used for the first layer described above.

### 3. Third layer

The third layer in the present embodiment includes a third olefin based resin, and a melt mass flow rate measured according to JIS K7210-1:2014 at a temperature of 190°C and a load of 2.16 kg is 0.8 g/10 minutes or more.

The properties and materials of the third layer are similar to the properties and materials of the first layer described above.

### 4. Sealing material sheet for solar cell module

The sealing material sheet for a solar cell module in the present embodiment is obtained by shape forming the first layer composition, the second layer composition, and the third layer composition using conventionally known methods. Examples thereof may include shape forming methods commonly used for thermoplastic resins, that is, various shape forming methods such as injection molding, extrusion molding, hollow molding, compression molding, and rotational molding. Example s thereof may include a method of molding by co-extrusion using three types of melt-kneading extruders. Also, in order to suppress blocking when winding the sealing material sheet for a solar cell module, the surface may be roughened using, for example, a mat roll.

In particular, the sealing material sheet for a solar cell module in the present embodiment is preferably obtained by carrying out the weak cross-linking treatment during shape forming. In order to promote a weak cross-linking reaction during shape forming, the shape forming temperature is preferably equal to or more than 50°C higher than the melting point of the first olefin based resin, equal to or more than 50°C higher than the melting point of the second olefin based resin, and equal to or more than 50°C higher than the melting point of the third olefin based resin. Specifically, the shape forming temperature is preferably 100°C or more and 250°C or less, and more preferably 190°C or more and 230°C or less. In the present disclosure, the added amount of the cross-linking agent is low. Therefore, although the MFR decreases due to the cross-linking, the degree of the decrease is small. For this reason, weak cross-linking can proceed during melt shape forming. And even with a small amount of cross-linking agent and substantially no cross-linking assistant, weak cross-linking of the first olefin based resin, the second olefin based resin and the third olefin based resin proceeds. Incidentally, since the shape forming temperature is equal to or more than the one-minute half-life period temperature of the cross-linking agent, almost no cross-linking agent remains after shape forming. For this reason, weak cross-linking ends at this form shaping stage.

In the sealing material sheet for a solar cell module weakly cross-linked in this way, the density is maintained, and the heat resistance is improved while having sufficient film forming ability. The density of the sealing material sheet for a solar cell module is approximately equivalent to the density of the olefin based resin that is a main raw material, and it does not increase. Therefore, the transparency is maintained. Meanwhile, as described above, the added amount of the cross-linking agent is low. Therefore, although the MFR decreases due to the cross-linking, the degree of the decrease is small. Therefore, while remaining within the range of MFR capable of shape forming, the heat resistance is improved. This is the effect of the weak cross-linking. Normally, there is a positive correlation between the MFR of a resin and its density. However, it is possible to reduce the MFR within the range of MFR capable of shape forming, without changing the density.

The MFR of the sealing material sheet for a solar cell module in the present embodiment is preferably 0.20 g/10 minutes or more, more preferably 0.25 g/10 minutes or more, and further preferably 0.30 g/10 minutes or more. Meanwhile, the MFR of the sealing material sheet for a solar cell module in the present embodiment is preferably 0.80 g/10 minutes or less, more preferably 0.75 g/10 minutes or less, and further preferably 0.70 g/10 minutes or less. That is, the MFR of the sealing material sheet for a solar cell module in the present embodiment is preferably 0.20 g/10 minutes or more and 0.80 g/10 minutes or less, more preferably 0.25 g/10 minutes or more and 0.75 g/10 minutes or less, and further preferably 0.30 g/10 minutes or more and 0.70 g/10 minutes or less. The method for measuring the MFR of the sealing material sheet for a solar cell module is similar to the method for measuring the MFR of the first layer.

The method for adjusting the MFR of the sealing material sheet for a solar cell module is similar to the method for adjusting the MFR of the first layer.

The gel fraction of the sealing material sheet for a solar cell module in the present embodiment is similar to the gel fraction of the first layer.

The thickness of the sealing material sheet for a solar cell module in the present embodiment is, for example, 3 µm or more and 800 µm or less.

As for the ratio between the thickness of the first layer, the thickness of the second layer and the thickness of the third layer, when the thickness of the first layer is regarded as 1, the thickness of the second layer is preferably 1 or more and 8 or less, and the thickness of the third layer is preferably 1. When the thickness ratio is in the above range, the adhesion between the first layer and the third layer of the sealing material sheet for a solar cell module and other members can be improved while maintaining the heat resistance of the sealing material sheet for a solar cell module.

The thickness of the first layer and the thickness of the third layer are preferably, for example, 1 µm or more and 120 µm or less. When the thickness of the first layer and the thickness of the third layer are in the above range, the adhesion between the first layer and the third layer of the sealing material sheet for a solar cell module and other members can be improved.

Also, the thickness of the second layer is preferably, for example, 1 µm or more and 600 µm or less. When the thickness of the second layer is in the above range, the heat resistance of the sealing material sheet for a solar cell module can be improved.

Incidentally, as described above, in the sealing material sheet for a solar cell module, it is sometimes difficult to distinguish the interface between the first layer, the second layer and the third layer. For example, when the density of the olefin based resin included in each layer is close to each other, it is difficult to distinguish the interface between each layer. In such a case, the interface of each layer can be determined by the gel fraction, or the interface of each layer can be determined by MFR.

When the interface of each layer is determined by the gel fraction, the sealing material sheet for a solar cell module is equally divided into three or more regions in the thickness direction, and the gel fraction of each region is determined. When the gel fractions of the two adjacent regions are different, the interface of the two regions is regarded as the interface of each layer. In this case, the difference between the gel fraction of the two adjacent regions is more than 0%, preferably 1% or more, and more preferably 2% or more. Also, in this case, the difference of the gel fractions of the two adjacent regions is preferably 25% or less, more preferably 20% or less, and further preferably 15% or less. That is, the difference of the gel fractions of the two adjacent regions is preferably more than 0% and 25% or less, more preferably 1% or more and 20% or less, and further preferably 2% or more and 15% or less. The number of divisions in the thickness direction of the sealing material sheet for a solar cell module is a multiple of 3.

When the interface of each layer is determined by the MFR, the sealing material sheet for a solar cell module is equally divided into three or more regions in the thickness direction, and the MFR of each region is measured. When the MFR of the two adjacent regions are different, the interface of the two regions is regarded as the interface of each layer. In this case, the MFR for each region corresponds to the MFR of the first layer, second layer and third layer described above. The number of divisions in the thickness direction of the sealing material sheet for a solar cell module is a multiple of 3.

### II. Second embodiment of sealing material sheet for solar cell module

The second embodiment of the sealing material sheet for a solar cell module in the present disclosure comprises a first surface and a second surface facing the first surface, and including an olefin based resin, wherein when each region obtained by equally dividing the sealing material sheet for a solar cell module into 10 regions in a thickness direction is numbered from a first region to a tenth region, in order from a first surface side toward a second surface side, a melt mass flow rate of the first region, measured according to JIS K7210-1:2014 at a temperature of 190°C and a load of 2.16 kg, is 0.8 g/10 minutes or more; a melt mass flow rate of the fifth region, measured according to JIS K7210-1:2014 at a temperature of 190°C and a load of 2.16 kg, is 0.4 g/10 minutes or less; and a melt mass flow rate of the tenth region, measured according to JIS K7210-1:2014 at a temperature of 190°C and a load of 2.16 kg, is 0.8 g/10 minutes or more.

FIG. 2 is a schematic cross-sectional view exemplifying a sealing material sheet for a solar cell module in the present embodiment. As shown in FIG. 2, the sealing material sheet for a solar cell module 10 comprises a first surface S1 and a second surface S2 facing the first surface S1, and including olefin based resin. When each region obtained by equally dividing the sealing material sheet for a solar cell module 10 into 10 regions in a thickness direction D is numbered as first region 5a, second region 5b, third region 5c ... and tenth region 5j, in order from the first surface S1 side toward the second surface S2 side, the MFR of the first region 5a, fifth region 5e and tenth region 5j are respectively in a predetermined range.

According to the present embodiment, since the MFR of the first region and the MFR of the tenth region are a predetermined value or more, the fluidity at low temperature is high so that the adhesion between the sealing material sheet for a solar cell module and other members can be improved, and low-temperature lamination process is possible in the production of a solar cell module using the sealing material sheet for a solar cell module. Also, since the flexibility at low temperature is high, it is possible to suppress the cracking of the solar cell during lamination process. Furthermore, it is possible to improve the embedding properties and convexoconcave following capability during the lamination process of the solar cell. Also, according to the present embodiment, since the MFR of the region where the MFR thereof is different from the MFR of the first region and the MFR of the tenth region, for example, the fifth region is a predetermined value of less, the fluidity during heating is low so that the heat resistance of the sealing material sheet for a solar cell module can be improved. Therefore, in the present embodiment, it is possible to achieve both low-temperature lamination process and heat resistance simultaneously. Therefore, the sealing material sheet for a solar cell module in the present embodiment is preferable for the solar cell module using a perovskite solar cell.

Hereinafter, the sealing material sheet for a solar cell module of the present embodiment will be described for each configuration.

### 1. Properties of sealing material sheet for solar cell module

### (1) MFR

Since the MFR of the first region is similar to the MFR of the first layer in the first embodiment described above, the explanation is omitted herein.

Since the MFR of the fifth region is similar to the MFR of the second layer in the first embodiment described above, the explanation is omitted herein.

Since the MFR of the tenth region is similar to the MFR of the third layer in the first embodiment described above, the explanation is omitted herein.

Examples of the method for equally dividing the sealing material sheet for a solar cell module in the thickness direction may include a method to slice the sealing material sheet for a solar cell module using, for example, a microtome.

Since the MFR of the sealing material sheet for a solar cell module in the present embodiment is similar to the MFR of the sealing material sheet for a solar cell module in the first embodiment described above, the explanation is omitted herein.

### (2) Gel fraction

Since the gel fraction of the first region is similar to the gel fraction of the first layer in the first embodiment described above, the explanation is omitted herein.

Since the gel fraction of the fifth region is similar to the gel fraction of the second layer in the first embodiment described above, the explanation is omitted herein.

Since the gel fraction of the tenth region is similar to the gel fraction of the third layer in the first embodiment described above, the explanation is omitted herein.

Since the gel fraction of the sealing material sheet for a solar cell module in the present embodiment is similar to the gel fraction of the sealing material sheet for a solar cell module in the first embodiment described above, the explanation is omitted herein.

### (3) Weight-average molecular weight

Since the weight-average molecular weight of the first region is similar to the weight-average molecular weight of the first layer in the first embodiment described above, the explanation is omitted herein.

Since the weight-average molecular weight of the fifth region is similar to the weight-average molecular weight of the second layer in the first embodiment described above, the explanation is omitted herein.

Since the weight-average molecular weight of the tenth region is similar to the weight-average molecular weight of the third layer in the first embodiment described above, the explanation is omitted herein.

### (4) Thickness

The thickness of the sealing material sheet for a solar cell module in the present embodiment is similar to the thickness of the sealing material sheet for a solar cell module in the first embodiment described above.

### 2. Materials for sealing material sheet for solar cell module

The sealing material sheet for a solar cell module in the present embodiment includes an olefin based resin. The olefin based resin is similar to the olefin based resin respectively used for the first layer, second layer and third layer in the first embodiment described above.

The sealing material sheet for a solar cell module in the present embodiment may include a silane component. The silane component is similar to the silane component used for the first layer in the first embodiment described above.

When shape forming the sealing material sheet for a solar cell module in the present embodiment, a cross-linking agent may be used. Also, when shape forming the sealing material sheet for a solar cell module in the present embodiment, a cross-linking assistant may be used. The cross-linking agent and cross-linking assistant are similar to the cross-linking agent and cross-linking assistant used for the first layer in the first embodiment described above.

The sealing material sheet for a solar cell module in the present embodiment may further include other components. The other components are similar to the other components used for the first layer in the first embodiment described above.

### III. Third embodiment of sealing material sheet for solar cell module

The third embodiment of the sealing material sheet for a solar cell module in the present disclosure comprises: a first layer including a first olefin based resin, and a melt mass flow rate measured according to JIS K7210-1:2014 at a temperature of 190°C and a load of 2.16 kg is 0.8 g/10 minutes or more; and a second layer including a second olefin based resin, and a melt mass flow rate measured according to JIS K7210-1:2014 at a temperature of 190°C and a load of 2.16 kg is 0.4 g/10 minutes or less.

FIG. 3 is a schematic cross-sectional view exemplifying a sealing material sheet for a solar cell module in the present embodiment. As shown in FIG. 3, the sealing material sheet for a solar cell module 10 includes a first layer 1 including a first olefin based resin, and the MFR is in a predetermined range; and a second layer 2 including a second olefin based resin, and the MFR is in a predetermined range.

According to the present embodiment, since the MFR of the first layer is a predetermined value or more, the fluidity at low temperature is high so that the adhesion between the sealing material sheet for a solar cell module and other members can be improved, and low-temperature lamination process is possible in the production of a solar cell module using the sealing material sheet for a solar cell module. Also, since the flexibility at low temperature is high, it is possible to suppress the cracking of the solar cell during lamination process. Furthermore, it is possible to improve the embedding properties and convexoconcave following capability during lamination process of the solar cell. Also, according to the present embodiment, when the MFR of the second layer is a predetermined value or less, the fluidity during heating is low so that the heat resistance of the sealing material sheet for a solar cell module can be improved. Therefore, in the present embodiment, it is possible to achieve both low-temperature lamination process and heat resistance simultaneously. Therefore, the sealing material sheet for a solar cell module in the present embodiment is preferable for the solar cell module using a perovskite solar cell.

Hereinafter, the sealing material sheet for a solar cell module of the present embodiment will be described for each configuration.

### 1. First layer

Since the first layer is similar to the first layer in the first embodiment described above, the explanation is omitted herein.

### 2. Second layer

Since the second layer is similar to the second layer in the first embodiment described above, the explanation is omitted herein.

### 3. Sealing material sheet for solar cell module

Since the properties and thickness of the sealing material sheet for a solar cell module are similar to the sealing material sheet for a solar cell module in the first embodiment described above, the explanation is omitted herein.

The thickness of the first layer, thickness of the second layer, and the ratio between the thickness of the first layer and the thickness of the second layer are similar to the sealing material sheet for a solar cell module in the first embodiment described above.

### IV. Fourth embodiment of sealing material sheet for solar cell module

The fourth embodiment of the sealing material sheet for a solar cell module in the present disclosure comprises a first surface and a second surface facing the first surface, and including an olefin based resin, wherein when each region obtained by equally dividing the sealing material sheet for a solar cell module into 10 regions in a thickness direction is numbered from a first region to a tenth region, in order from a first surface side toward a second surface side, a melt mass flow rate of the first region, measured according to JIS K7210-1:2014 at a temperature of 190°C and a load of 2.16 kg, is 0.8 g/10 minutes or more; and a melt mass flow rate of the tenth region, measured according to JIS K7210-1:2014 at a temperature of 190°C and a load of 2.16 kg, is 0.4 g/10 minutes or less.

FIG. 2 is a schematic cross-sectional view exemplifying a sealing material sheet for a solar cell module in the present embodiment. As shown in FIG. 2, the sealing material sheet for a solar cell module 10 comprises a first surface S1 and a second surface S2 facing the first surface S1, and including olefin based resin. When each region obtained by equally dividing the sealing material sheet for a solar cell module 10 into 10 regions in a thickness direction D is numbered as first region 5a, second region 5b, third region 5c ... and tenth region 5j, in order from the first surface S1 side toward the second surface S2 side, the MFR of the first region 5a and tenth region 5j are respectively in a predetermined range.

According to the present embodiment, since the MFR of the first region is a predetermined value or more, the fluidity at low temperature is high so that the adhesion between the sealing material sheet for a solar cell module and other members can be improved, and low-temperature lamination process is possible in the production of a solar cell module using the sealing material sheet for a solar cell module. Also, since the flexibility at low temperature is high, it is possible to suppress the cracking of the solar cell during lamination process. Furthermore, it is possible to improve the embedding properties and convexoconcave following capability during lamination process of the solar cell. Also, according to the present embodiment, when the MFR of the tenth region is a predetermined value or less, the fluidity during heating is low so that the heat resistance of the sealing material sheet for a solar cell module can be improved. Therefore, in the present embodiment, it is possible to achieve both low-temperature lamination process and heat resistance simultaneously. Therefore, the sealing material sheet for a solar cell module in the present embodiment is preferable for the solar cell module using a perovskite solar cell.

Hereinafter, the sealing material sheet for a solar cell module of the present embodiment will be described for each configuration.

### 1. Properties of sealing material sheet for solar cell module

### (1) MFR

Since the MFR of the first region is similar to the MFR of the first layer in the first embodiment described above, the explanation is omitted herein.

Since the MFR of the tenth region is similar to the MFR of the second layer in the first embodiment described above, the explanation is omitted herein.

Examples of the method for equally dividing the sealing material sheet for a solar cell module in the thickness direction may include a method to slice the sealing material sheet for a solar cell module using, for example, a microtome.

Since the MFR of the sealing material sheet for a solar cell module in the present embodiment is similar to the MFR of the sealing material sheet for a solar cell module in the first embodiment described above, the explanation is omitted herein.

### (2) Gel fraction

Since the gel fraction of the first region is similar to the gel fraction of the first layer in the first embodiment described above, the explanation is omitted herein.

Since the gel fraction of the tenth region is similar to the gel fraction of the second layer in the first embodiment described above, the explanation is omitted herein.

Since the gel fraction of the sealing material sheet for a solar cell module in the present embodiment is similar to the gel fraction of the sealing material sheet for a solar cell module in the first embodiment described above, the explanation is omitted herein.

### (3) Weight-average molecular weight

Since the weight-average molecular weight of the first region is similar to the weight-average molecular weight of the first layer in the first embodiment described above, the explanation is omitted herein.

Since the weight-average molecular weight of the tenth region is similar to the weight-average molecular weight of the second layer in the first embodiment described above, the explanation is omitted herein.

### (4) Thickness

The thickness of the sealing material sheet for a solar cell module in the present embodiment is similar to the thickness of the sealing material sheet for a solar cell module in the first embodiment described above.

### 2. Materials for sealing material sheet for solar cell module

The sealing material sheet for a solar cell module in the present embodiment includes an olefin based resin. The olefin based resin is similar to the olefin based resin respectively used for the first layer and second layer in the first embodiment described above.

The sealing material sheet for a solar cell module in the present embodiment may include a silane component. The silane component is similar to the silane component used for the first layer in the first embodiment described above.

When shape forming the sealing material sheet for a solar cell module in the present embodiment, a cross-linking agent may be used. Also, when shape forming the sealing material sheet for a solar cell module in the present embodiment, a cross-linking assistant may be used. The cross-linking agent and cross-linking assistant are similar to the cross-linking agent and cross-linking assistant used for the first layer in the first embodiment described above.

The sealing material sheet for a solar cell module in the present embodiment may further include other components. The other components are similar to the other components used for the first layer in the first embodiment described above.

### B. Solar cell module

The solar cell module in the present disclosure comprises a solar cell; and the sealing material sheet for a solar cell module described above.

### 1 Configuration of solar cell module

The solar cell module in the present disclosure only needs to include a solar cell; and the sealing material sheet for a solar cell module described above. The sealing material sheet for a solar cell module described above is preferable for the solar cell module using a perovskite solar cell. The followings are examples of the configuration of a solar cell module including a perovskite solar cell.

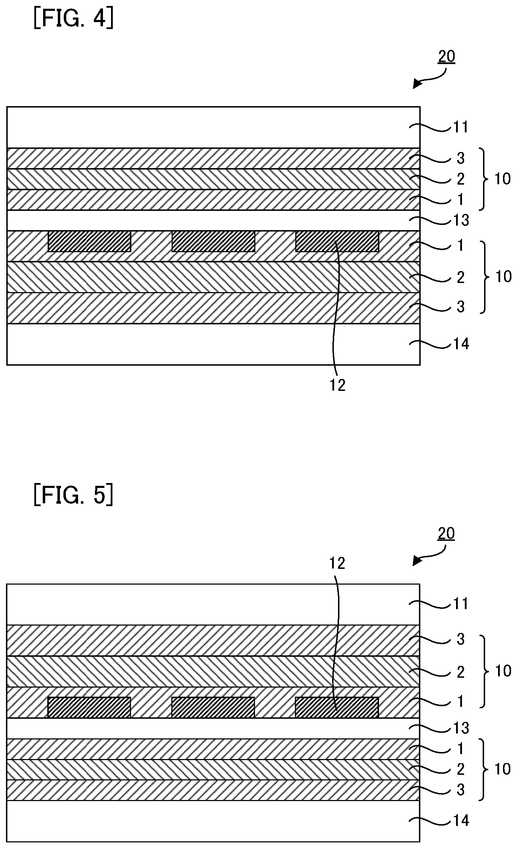

As shown in FIG. 4, the solar cell module 20 may include a surface member 11, a sealing material sheet for a solar cell module 10, a substrate 13, a perovskite solar cell 12 disposed on one surface of the substrate 13, the sealing material sheet for a solar cell module 10, and a rear surface member 14 in this order. Also, as shown in FIG. 5, the solar cell module 20 may include a rear surface member 14, a sealing material sheet for a solar cell module 10, a substrate 13, a perovskite solar cell 12 disposed on one surface of the substrate 13, the sealing material sheet for a solar cell module 10, and a surface member 11 in this order. The surface member 11 is disposed on the light-receptive surface side of the perovskite solar cell 12. Also, the sealing material sheet for a solar cell module 10 is arranged so that the first layer 1 faces the perovskite solar cell 12 and the third layer 3 faces the surface member 11 or the rear surface member 14. In these cases, the sealing material sheet for a solar cell module in the first embodiment and the second embodiment are used.

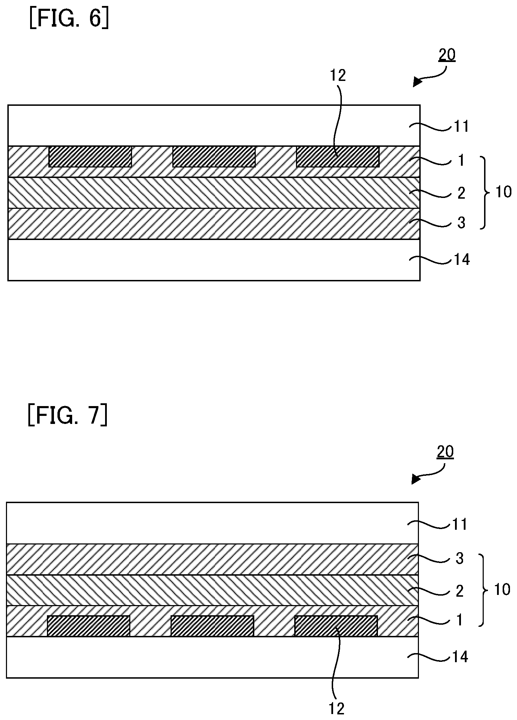

Also, as shown in FIG. 6, the solar cell module 20 may include a surface member 11, a perovskite solar cell 12 disposed on one surface of the surface member 11, the sealing material sheet for a solar cell module 10, and a rear surface member 14 in this order. In this case, the surface member 11 also functions as a substrate on which the perovskite solar cell 12 is disposed. Also, as shown in FIG. 7, the solar cell module 20 may include a rear surface member 14, a perovskite solar cell 12 disposed on one surface of the rear surface member 14, the sealing material sheet for a solar cell module 10, and a surface member 11 in this order. In this case, the rear surface member 14 also functions as a substrate on which the perovskite solar cell 12 is disposed. In these cases, sealing material sheet for a solar cell module in the first embodiment and the second embodiment are used.

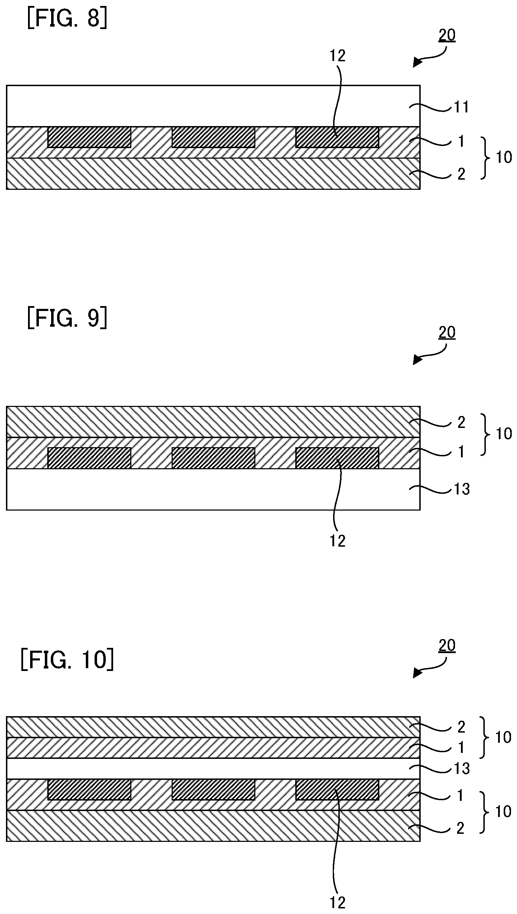

Also, as shown in FIG. 8, the solar cell module 20 may include a surface member 11, a perovskite solar cell 12 disposed on one surface of the surface member 11, and the sealing material sheet for a solar cell module 10 in this order. In this case, the surface member 11 is disposed on the light-receptive surface side of the perovskite solar cell 12, and also functions as a substrate on which the perovskite solar cell 12 is disposed. Also, as shown in FIG. 9, the solar cell module 20 may include a rear surface member 14, a perovskite solar cell 12 disposed on one surface of the rear surface member 14, and the sealing material sheet for a solar cell module 10 in this order. In this case, the sealing material sheet for a solar cell module 10 is disposed on the light-receptive surface side of the solar cell 12, and the rear surface member 14 also functions as a substrate on which the perovskite solar cell 12 is disposed. Also, the sealing material sheet for a solar cell module 10 is arranged so that the first layer 1 faces the perovskite solar cell 12 and the second layer 2 faces the side that is opposite to the perovskite solar cell 12. In these cases, the sealing material sheet for a solar cell module in the third embodiment and the fourth embodiment are used.

Also, as shown in FIG. 10, the solar cell module 20 may include a sealing material sheet for a solar cell module 10, a substrate 13, a perovskite solar cell 12 disposed on one surface of the substrate 13, and the sealing material sheet for a solar cell module 10 in this order. In this case, either one of the two sealing material sheets for a solar cell module 10 may be disposed on the light-receptive surface side of the perovskite solar cell 12. Also, the sealing material sheet for a solar cell module 10 is arranged so that the first layer 1 faces the perovskite solar cell 12 and the second layer 2 faces the side that is opposite to the perovskite solar cell 12. In these cases, the sealing material sheet for a solar cell module in the third embodiment and the fourth embodiment are used.

Although not shown in the drawings, the solar cell module may also be a tandem-type solar cell module in which perovskite solar cells and other solar cells are stacked via a sealing material sheet for a solar cell module. Examples thereof may include the following configurations.

The solar cell module may include a surface member, a sealing material sheet for a solar cell module, a silicon solar cell, a sealing material sheet for a solar cell module, a substrate, a perovskite solar cell disposed on one surface of the substrate, a sealing material sheet for a solar cell module, and a rear surface member in this order. The solar cell module may include a rear surface member, a sealing material sheet for a solar cell module, a substrate, a perovskite solar cell disposed on one surface of the substrate, a sealing material sheet for a solar cell module, a silicon solar cell, a sealing material sheet for a solar cell module, and a surface member in this order. The solar cell module may include a surface member, a sealing material sheet for a solar cell module, a substrate, a perovskite solar cell disposed on one surface of the substrate, a sealing material sheet for a solar cell module, a silicon solar cell, a sealing material sheet for a solar cell module, and a rear surface member in this order. The solar cell module may include a rear surface member, a sealing material sheet for a solar cell module, a silicon solar cell, a sealing material sheet for a solar cell module, a substrate, a perovskite solar cell disposed on one surface of the substrate, a sealing material sheet for a solar cell module, and a surface member in this order. The solar cell module may include a surface member, a perovskite solar cell disposed on one surface of the surface member, a sealing material sheet for a solar cell module, a silicon solar cell, a sealing material sheet for a solar cell module, and a rear surface member in this order. In this case, the surface member also functions as a substrate on which the perovskite solar cell is disposed. The solar cell module may include a rear surface member, a perovskite solar cell disposed on one surface of the rear surface member, a sealing material sheet for a solar cell module, a silicon solar cell, a sealing material sheet for a solar cell module, and a surface member in this order. In this case, the rear surface member also functions as a substrate on which the perovskite solar cell is disposed. In these cases, sealing material sheet for a solar cell module in the first embodiment and the second embodiment are used.

The solar cell module may include a substrate, a perovskite solar cell disposed on one surface of the substrate, a first sealing material sheet for a solar cell module, a silicon solar cell, and a second sealing material sheet for a solar cell module in this order. In this case, either one of the substrate and the first sealing material sheets for a solar cell module may be disposed on the light-receptive surface side of the perovskite solar cell. In these cases, for the first sealing material sheet for a solar cell module, the sealing material sheet for a solar cell module in the first embodiment and the second embodiment are used. Also, for the second sealing material sheet for a solar cell module, the sealing material sheet for a solar cell module in the third embodiment and the fourth embodiment are used.

The solar cell module may include a first sealing material sheet for a solar cell module, a substrate, a perovskite solar cell disposed on one surface of the substrate, a second sealing material sheet for a solar cell module, a silicon solar cell, and a third sealing material sheet for a solar cell module in this order. In this case, either one of the substrate and the second sealing material sheets for a solar cell module may be disposed on the light-receptive surface side of the perovskite solar cell. In this case, for the first sealing material sheet for a solar cell module and the third sealing material sheet for a solar cell module, the sealing material sheet for a solar cell module in the third embodiment and the fourth embodiment are used. Also, for the second sealing material sheet for a solar cell module, the sealing material sheet for a solar cell module in the first embodiment and the second embodiment are used.

The solar cell module may include a first sealing material sheet for a solar cell module, a silicon solar cell, a second sealing material sheet for a solar cell module, a substrate, a perovskite solar cell disposed on one surface of the substrate, and a third sealing material sheet for a solar cell module in this order. In this case, either one of the substrate and the third sealing material sheets for a solar cell module may be disposed on the light-receptive surface side of the perovskite solar cell. In this case, for the first sealing material sheet for a solar cell module and the third sealing material sheet for a solar cell module, the sealing material sheet for a solar cell module in the third embodiment and the fourth embodiment are used. Also, for the second sealing material sheet for a solar cell module, the sealing material sheet for a solar cell module in the first embodiment and the second embodiment are used.

Each constitution of the solar cell module in the present disclosure is hereinafter described.

### (1) Sealing material sheet for solar cell module

The sealing material sheet for a solar cell module is similar to the description in the section "A. Sealing material sheet for solar cell module" above.

In the solar cell module, when members are respectively disposed on both surfaces of the sealing material sheet for a solar cell module, for this sealing material sheet for a solar cell module, the sealing material sheet for a solar cell module in the first embodiment and the second embodiment are used.

Meanwhile, in the solar cell module, when a member is disposed only on one surface of the sealing material sheet for a solar cell module and another surface of the sealing material sheet for a solar cell module is exposed, for this sealing material sheet for a solar cell module, the sealing material sheet for a solar cell module in the third embodiment and the fourth embodiment are used.

### (2) Solar cell

The solar cell is preferably an organic based solar cell, and more preferably a perovskite solar cell. In the case of a tandem type solar cell module, examples thereof may include a tandem type solar cell module in which a perovskite solar cell and a silicon solar cell are stacked; and a tandem type solar cell module in which a perovskite solar cell and a CIGS solar cell element are stacked.

### (3) Surface member

The surface member is disposed on the light-receptive surface side of the solar cell, and is a member configured to protect the solar cell. The transparency of the surface member is not particularly limited as long as it is to the extent that it does not interfere with the power generation of the solar cell. Transparent substrates may be used as the surface member, and examples thereof may include a glass substrate and a resin substrate. Examples of resins constituting the resin substrate may include acrylic resin, polyamideimide, polyester, fluororesin, polyetheretherketone (PEEK), polyphthalamide (PPA), polyphenylene sulfide (PPS), polycarbonate, polyethersulfone, polysulfone, and polyetherimide. Examples of the polyester may include polyethylene terephthalate (PET), and polyethylene naphthalate (PEN). Examples of fluororesin may include polytetrafluoroethylene (PTFE) and ethylene tetrafluoroethylene (ETFE).

### (4) Rear surface member

The rear surface member is disposed on the rear surface side of the solar cell, and is a member configured to protect the solar cell. For the rear surface member, back sheets commonly used for solar cell modules can be used, and examples thereof may include a glass substrate, a resin film, and a metal sheet. The resin constituting the resin film is similar to the resin constituting the resin substrate used for the surface member described above. The resin film may include an inorganic vapor deposition film on its surface. Examples of the metal constituting the metal sheet may include tin, aluminum, and stainless steel. Also, the rear surface member may be a single layer, and may be a multilayer.

### (5) Substrate

The substrate is a component on which the solar cell is formed. As the substrate, glass substrates and resin films may be used. The resin film is similar to the resin film used for the rear surface member described above.

### C. Method for producing solar cell module

The method for producing a solar cell module in the present disclosure comprises a lamination step of heating and pressurizing a stacked body including a solar cell and the sealing material sheet for a solar cell module described above, wherein, a heating temperature in the lamination step is 60°C or more and 120°C or less.

In the present disclosure, since the sealing material sheet for a solar cell module described above is used, low-temperature lamination process as described above is possible.

The heating temperature in the lamination step is 120°C or less, may be 115°C or less, and may be 110°C or less. Meanwhile, the heating temperature is 60°C or more, may be 65°C or more, and may be 70°C or more. That is, the heating temperature is, 60°C or more and 120°C or less, may be 65°C or more and 115°C or less, and may be 70°C or more and 110°C or less.

The stacked body only needs to include at least a solar cell and a sealing material sheet for a solar cell module. The configuration of the stacked body is similar to the configuration of the solar cell module described above.

Examples of the method for heating and pressuring the stacked body may include a vacuum heat lamination method and roll pressing method. The pressing time and pressure in the pressing treatment are not particularly limited, and it is preferable that they are conditions that do not degrade the solar cells. When heating and pressurizing the stacked body, a release material such as tetrafluoroethylene copolymer and polytetrafluoroethylene may be sandwiched between the pressing device and the stacked body.

Incidentally, the present disclosure is not limited to the embodiments. The embodiments are exemplification, and any other variations are intended to be included in the technical scope of the present disclosure if they have substantially the same constitution as the technical idea described in the claim of the present disclosure and offer similar operation and effect thereto.

### Examples

The present disclosure is hereinafter explained in further details with reference to Examples and Comparative Examples.

### [Materials]

The following materials were used.
▪ Polyethylene based resin: M-LLDPE with melting point of 60°C, density of 0.880 g/cm³, and MFR of 3.5 g/10 minutes
▪ Silane-modified polyolefin based resin with melting point of 60°C, density of 0.884 g/cm³, and MFR of 1.8 g/10 minutes
▪ Cross-linking agent masterbatch: a masterbatch was obtained by impregnating 0.5 parts by mass of 2,5-dimethyl-2,5-di(t-butylperoxy)hexane, as a cross-linking agent, into 100 parts by mass of M-LLDPE pellets with melting point of 60°C, density of 0.880 g/cm³, and MFR of 3.1 g/10 minutes
▪ Weather resistant agent masterbatch: a masterbatch was obtained by mixing, melting and processing 50 parts by mass of a hindered amine based light stabilizer into 100 parts by mass of M-LLDPE with density of 0.880 g/cm³

### [Examples 1 to 4 and Comparative Examples 1 to 4]

Compositions for respective layers having the composition shown in the following Table 1 were produced using the materials described above. A sealing material sheet including a first layer, a second layer and a third layer stacked in this order was obtained by melted the compositions for the respective layers at an extrusion temperature of 210°C, co-extruding the three layers, using a film shape forming device with a φ30 mm extruder and a 300 mm wide T-die for the respective layers, and adjusting so that the thickness ratio of each layer was first layer: second layer: third layer = 1:7:1 and the total thickness of the sealing material sheet was 450 µm.

**[Table 1]**

| | | Comp. Ex. 1 | Comp. Ex. 2 | Example 1 | Example 2 | Example 3 | Example 4 | Comp. Ex. 3 | Comp. Ex. 4 |
|---|---|---|---|---|---|---|---|---|---|
| 1st layer composition (pts. mass) | Polyethylene based resin | 89 | 87 | 89 | 88 | 87 | 89 | 85 | 82 |
| | Silane-modified polyolefin based resin | 15 | 15 | 15 | 15 | 15 | 15 | 15 | 15 |
| | Cross-linking agent MB | 1 | 3 | 1 | 2 | 3 | 1 | 5 | 8 |
| | Weather resistant agent MB | 5 | 5 | 5 | 5 | 5 | 5 | 5 | 5 |
| 2nd layer composition (pts. mass) | Polyethylene based resin | 99 | 99 | 96 | 96 | 96 | 94 | 96 | 96 |
| | Silane-modified polyolefin based resin | 1 | 1 | 1 | 1 | 1 | 1 | 1 | 1 |
| | Cross-linking agent MB | 5 | 5 | 8 | 8 | 8 | 10 | 8 | 8 |
| | Weather resistant agent MB | 5 | 5 | 5 | 5 | 5 | 5 | 5 | 5 |
| 3rd layer composition (pts. mass) | Polyethylene based resin | 89 | 87 | 89 | 88 | 87 | 89 | 85 | 82 |
| | Silane-modified polyolefin based resin | 15 | 15 | 15 | 15 | 15 | 15 | 15 | 15 |
| | Cross-linking agent MB | 1 | 3 | 1 | 2 | 3 | 1 | 5 | 8 |
| | Weather resistant agent MB | 5 | 5 | 5 | 5 | 5 | 5 | 5 | 5 |
| Cross-link agt. content (mass%) | 1st layer composition | 0.0045 | 0.0136 | 0.0045 | 0.0091 | 0.0136 | 0.0045 | 0.0227 | 0.0364 |
| | 2nd layer composition | 0.0227 | 0.0227 | 0.0364 | 0.0364 | 0.0364 | 0.0455 | 0.0364 | 0.0364 |
| | 3rd layer composition | 0.0045 | 0.0136 | 0.0045 | 0.0091 | 0.0136 | 0.0045 | 0.0227 | 0.0364 |

### [Evaluation]

### (1) MFR

The MFR of each layer and the MFR of the sealing member sheet were measured according to Method A in JIS K7210-1:2014 at a temperature of 190°C and a load of 2.16 kg.

### (2) Gel fraction

For each layer and the sealing material sheet, the gel fraction was measured by the method described above.

### (3) Melting point

The melting point of the sealing material sheet was measured by differential scanning calorimetry (DSC) in accordance with the plastic transition temperature measuring method in JIS K7121:2012.

### (4) Total light transmittance

The total light transmittance of the sealing material sheet was measured according to JIS K7361-1:1997 with a haze meter HM150 from Murakami Color Research Laboratory Co., Ltd.

### (5) Haze

The haze of the sealing material sheet was measured according to JIS K7136:2000 with a haze meter HM150 from Murakami Color Research Laboratory Co., Ltd.

### (6) Yellowness (YI)

The YI of the sealing material sheet was measured according to JIS Z8722:2009 with a spectrophotometric colorimeter CM-700d from Konica Minolta, Inc., under conditions of light source of D65 and viewing angle of 10°.

### (7) Average transmittance at wavelength of 400 nm or more and 900 nm or less

Using a spectrophotometer V-650 from by JASCO Corporation, the transmittance of the sealing material sheet, at wavelength range of 400 nm or more and 900 nm or less, was measured and the average value thereof was obtained.

### (8) Adhesion strength with respect to glass

An ETFE (ethylene tetrafluoroethylene copolymer) film, a glass substrate, sealing material sheet, and an ETFE film were stacked in this order, and a vacuum lamination process was carried out under conditions of temperature of 90°C, vacuum evacuation time of 4 minutes, pressure maintaining time of 7 minutes and pressure of 100 kPa. Then, the sealing material sheet on the glass substrate was cut to a width of 15 mm, and a 180° peeling test was carried out using a Tensilon Universal Material Testing Instrument RTF-1150-H from A & D Co. Ltd. at a peeling angle of 180° and a peeling speed of 50 mm/min to measure the adhesion strength of the sealing material sheet with respect to the glass substrate.

In the peeling test, a white semi-tempered glass (JPT3.2: 75 mm × 50 mm × 3.2 mm) was used as the glass substrate. Then, the sealing material sheet closely adhered onto the glass substrate was cut to a width of 15 mm, and a 180° peeling test was carried out using a Tensilon Universal Material Testing Instrument RTF-1150-H from A & D Co. Ltd. at a peeling angle of 180° and a peeling speed of 50 mm/min to measure the adhesion strength of the sealing material sheet to the glass substrate.

### (9) Heat resistance test

Two sealing material sheets cut to a size of 75 mm × 50 mm and a second glass substrate with a thickness of 3.2 mm and a size of 75 mm × 50 mm were stacked in order on a first glass substrate with a thickness of 3.2 mm and a size of 250 mm square, and a vacuum lamination process was carried out under conditions of temperature of 90°C, vacuum evacuation time of 4 minutes, pressure maintaining time of 7 minutes and pressure of 100 kPa. The stacked body was then placed still vertically in an oven at 105°C for 500 hours. Subsequently, the displacement of the second glass substrate was measured. The heat resistance of the sealing material sheet was evaluated according to the following evaluation criteria.
A: The displacement of the second glass substrate was less than 10 mm.
B: The displacement of the second glass substrate was 10 mm or more.

### (10) Embedding Properties

A glass substrate with a thickness of 2.5 mm and a size of 200 mm square, a sealing material sheet cut to a size of 200 mm square, a solar cell, a sealing material sheet cut to a size of 200 mm square, and a glass substrate with a thickness of 2.5 mm were stacked in order, and a vacuum lamination process was carried out under conditions of temperature of 100°C, vacuum evacuation time of 10 minutes, pressure maintaining time of 10 minutes and pressure of 100 kPa to obtain a sample of a solar cell. For the solar cell, an n-type silicon cell with a thickness of 180 µm was used. The sample of the solar cell was visually observed, and the embedding properties of the solar cell was evaluated according to the following evaluation criteria.
A: No air bubbles remaining around or on the solar cell
B: Air bubbles remaining either around or on the solar cell
C: Air bubbles remaining both around and on the solar cell

### (11) Cell cracking

The sample of the solar cell was visually observed, and the cell cracking was evaluated according to the following evaluation criteria.
A: No cell cracks
B: Cell cracks present

**[Table 2]**

| | | Comp. Ex. 1 | Comp. Ex. 2 | Example 1 | Example 2 | Example 3 | Example 4 | Comp. Ex. 3 | Comp. Ex. 4 |
|---|---|---|---|---|---|---|---|---|---|
| MFR (g/10min) | First layer | 2.3 | 1.1 | 2.3 | 1.6 | 1.1 | 2.3 | 0.5 | 0.2 |
| | Second layer | 0.5 | 0.5 | 0.2 | 0.2 | 0.2 | 0.1 | 0.2 | 0.2 |
| | Third layer | 2.3 | 1.1 | 2.3 | 1.6 | 1.1 | 2.3 | 0.5 | 0.2 |
| | Sealing material sheet | 1 | 0.8 | 0.6 | 0.5 | 0.4 | 0.5 | 0.2 | 0.2 |
| Gel fraction (%) | First layer | 1 | 3 | 1 | 2 | 3 | 1 | 5 | 7 |
| | Second layer | 5 | 4 | 7 | 7 | 7 | 10 | 7 | 7 |
| | Third layer | 1 | 3 | 1 | 2 | 3 | 1 | 5 | 7 |
| | Diff. between 1st and 2nd | 4 | 1 | 6 | 5 | 4 | 9 | 2 | 0 |
| | Diff. between 3rd and 2nd | 4 | 1 | 6 | 5 | 4 | 9 | 2 | 0 |
| | Sealing material sheet | 4 | 3 | 6 | 5 | 3 | 8 | 5 | 7 |
| Melting point (°C) | | 52 | 52 | 51 | 49 | 51 | 49 | 47 | 47 |
| Total light transmittance (%) | | 92 | 92 | 92 | 92 | 92 | 92 | 92 | 92 |
| Haze (%) | | 2 | 2 | 2 | 2 | 2 | 2 | 1 | 1 |
| YI | | 1 | 1 | 1 | 1 | 1 | 1 | 1 | 1 |
| Transmittance (%) (400nm-900nm) | | 92 | 92 | 92 | 92 | 92 | 92 | 90 | 90 |
| Adhesion strength to glass (N/15mm) (90°C) | | 36 | 34 | 37 | 36 | 36 | 36 | 27 | 25 |
| Heat rstn. test (mm) | 105°( 500h | 61 | 48 | 6 | 5 | 6 | 4 | 4 | 2 |
| | 120°C 12h | 1 | 1 | 0 | 0 | 0 | 0 | 0 | 0 |
| Heat resistance | | B | B | A | A | A | A | A | A |
| Embedding poperties | | A | B | A | B | B | A | C | C |
| Cell cracking | | A | A | A | A | A | A | B | B |

From Table 2, it was confirmed that the sealing material sheet for a solar cell module in the present disclosure had high adhesion strength with respect to glass when vacuum laminated at 90°C, cell cracking was suppressed, and low-temperature lamination process was possible. Also, the sealing material sheet in the present disclosure had good heat resistance and it was shown that both low-temperature lamination process and heat resistance could be achieved simultaneously. Further, in the sealing material sheet for a solar cell module in the present disclosure, it was shown that, when the MFR of the first layer was within the preferable range, the embedding properties of the solar cell was also improved.

The present disclosure provides the following inventions.
[1] A sealing material sheet for a solar cell module comprising, in this order:
   a first layer including a first olefin based resin, and a melt mass flow rate measured according to JIS K7210-1:2014 at a temperature of 190°C and a load of 2.16 kg is 0.8 g/10 minutes or more;
   a second layer including a second olefin based resin, and a melt mass flow rate measured according to JIS K7210-1:2014 at a temperature of 190°C and a load of 2.16 kg is 0.4 g/10 minutes or less; and
   a third layer including a third olefin based resin, and a melt mass flow rate measured according to JIS K7210-1:2014 at a temperature of 190°C and a load of 2.16 kg is 0.8 g/10 minutes or more.
[2] The sealing material sheet for a solar cell module according to [1], wherein the melt mass flow rate of the first layer and the melt mass flow rate of the third layer are 1.7 g/10 minutes or more.
[3] The sealing material sheet for a solar cell module according to [1] or [2], wherein a melt mass flow rate of the sealing material sheet for a solar cell module measured according to JIS K7210-1:2014 at a temperature of 190°C and a load of 2.16 kg is 0.20 g/10 minutes or more and 0.80 g/10 minutes or less.
[4] The sealing material sheet for a solar cell module according to any one of [1] to [3], wherein a gel fraction of the first layer, a gel fraction of the second layer, and a gel fraction of the third layer are 25% or less.
[5] The sealing material sheet for a solar cell module according to any one of [1] to [4], wherein a difference between a gel fraction of the first layer and a gel fraction of the second layer is 0% or more and 25% or less; and a difference between a gel fraction of the third layer and the gel fraction of the second layer is 0% or more and 25% or less.
[6] A sealing material sheet for a solar cell module comprising a first surface and a second surface facing the first surface, and including an olefin based resin, wherein
   when each region obtained by equally dividing the sealing material sheet for a solar cell module into 10 regions in a thickness direction is numbered from a first region to a tenth region, in order from a first surface side toward a second surface side,
   a melt mass flow rate of the first region, measured according to JIS K7210-1:2014 at a temperature of 190°C and a load of 2.16 kg, is 0.8 g/10 minutes or more;
   a melt mass flow rate of the fifth region, measured according to JIS K7210-1:2014 at a temperature of 190°C and a load of 2.16 kg, is 0.4 g/10 minutes or less; and
   a melt mass flow rate of the tenth region, measured according to JIS K7210-1:2014 at a temperature of 190°C and a load of 2.16 kg, is 0.8 g/10 minutes or more.
[7] The sealing material sheet for a solar cell module according to [6], wherein a difference between a gel fraction of the first region and a gel fraction of the fifth region is 0% or more and 25% or less; and a difference between a gel fraction of the tenth region and the gel fraction of the fifth region is 0% or more and 25% or less.
[8] A sealing material sheet for a solar cell module comprising:
   a first layer including a first olefin based resin, and a melt mass flow rate measured according to JIS K7210-1:2014 at a temperature of 190°C and a load of 2.16 kg is 0.8 g/10 minutes or more; and
   a second layer including a second olefin based resin, and a melt mass flow rate measured according to JIS K7210-1:2014 at a temperature of 190°C and a load of 2.16 kg is 0.4 g/10 minutes or less.
[9] The sealing material sheet for a solar cell module according to [8], wherein the melt mass flow rate of the first layer is 1.7 g/10 minutes or more.
[10] The sealing material sheet for a solar cell module according to [8] or [9], wherein a melt mass flow rate measured according to JIS K7210-1:2014 at a temperature of 190°C and a load of 2.16 kg is 0.20 g/10 minutes or more and 0.80 g/10 minutes or less.
[11] The sealing material sheet for a solar cell module according to any one of [8] to [10], wherein a gel fraction of the first layer, and a gel fraction of the second layer are 25% or less.
[12] The sealing material sheet for a solar cell module according to any one of [8] to [11], wherein a difference between a gel fraction of the first layer and a gel fraction of the second layer is 0% or more and 25% or less.
[13] A sealing material sheet for a solar cell module comprising a first surface and a second surface facing the first surface, and including an olefin based resin, wherein
   when each region obtained by equally dividing the sealing material sheet for a solar cell module into 10 regions in a thickness direction is numbered from a first region to a tenth region, in order from a first surface side toward a second surface side,
   a melt mass flow rate of the first region, measured according to JIS K7210-1:2014 at a temperature of 190°C and a load of 2.16 kg, is 0.8 g/10 minutes or more; and
   a melt mass flow rate of the tenth region, measured according to JIS K7210-1:2014 at a temperature of 190°C and a load of 2.16 kg, is 0.4 g/10 minutes or less.
[14] The sealing material sheet for a solar cell module according to [13], wherein a difference between a gel fraction of the first region and a gel fraction of the tenth region is 0% or more and 25% or less.
[15] A solar cell module comprising a solar cell; and the sealing material sheet for a solar cell module according to any one of [1] to [14].
[16] The solar cell module according to [15], wherein the solar cell is a perovskite solar cell.
[17] A method for producing a solar cell module, the method comprising a lamination step of heating and pressurizing a stacked body including a solar cell and the sealing material sheet for a solar cell module according to any one of [1] to [14], wherein,
   a heating temperature in the lamination step is 60°C or more and 120°C or less.

### Reference Signs List

- 1: first layer
- 2: second layer
- 3: third layer
- 10: sealing material sheet for a solar cell module
- 11: surface member
- 12: perovskite solar cell
- 13: substrate
- 14: rear surface member
- 20: solar cell module

## Claims

1. A sealing material sheet for a solar cell module comprising, in this order:
a first layer including a first olefin based resin, and a melt mass flow rate measured according to JIS K7210-1:2014 at a temperature of 190°C and a load of 2.16 kg is 0.8 g/10 minutes or more;
a second layer including a second olefin based resin, and a melt mass flow rate measured according to JIS K7210-1:2014 at a temperature of 190°C and a load of 2.16 kg is 0.4 g/10 minutes or less; and
a third layer including a third olefin based resin, and a melt mass flow rate measured according to JIS K7210-1:2014 at a temperature of 190°C and a load of 2.16 kg is 0.8 g/10 minutes or more.

2. The sealing material sheet for a solar cell module according to claim 1, wherein the melt mass flow rate of the first layer and the melt mass flow rate of the third layer are 1.7 g/10 minutes or more.

3. The sealing material sheet for a solar cell module according to claim 1, wherein a melt mass flow rate measured according to JIS K7210-1:2014 at a temperature of 190°C and a load of 2.16 kg is 0.20 g/10 minutes or more and 0.80 g/10 minutes or less.

4. The sealing material sheet for a solar cell module according to claim 1, wherein a gel fraction of the first layer, a gel fraction of the second layer, and a gel fraction of the third layer are 25% or less.

5. The sealing material sheet for a solar cell module according to claim 1, wherein a difference between a gel fraction of the first layer and a gel fraction of the second layer is 0% or more and 25% or less; and a difference between a gel fraction of the third layer and the gel fraction of the second layer is 0% or more and 25% or less.

6. A sealing material sheet for a solar cell module comprising a first surface and a second surface facing the first surface, and including an olefin based resin, wherein
when each region obtained by equally dividing the sealing material sheet for a solar cell module into 10 regions in a thickness direction is numbered from a first region to a tenth region, in order from a first surface side toward a second surface side,
a melt mass flow rate of the first region, measured according to JIS K7210-1:2014 at a temperature of 190°C and a load of 2.16 kg, is 0.8 g/10 minutes or more;
a melt mass flow rate of the fifth region, measured according to JIS K7210-1:2014 at a temperature of 190°C and a load of 2.16 kg, is 0.4 g/10 minutes or less; and
a melt mass flow rate of the tenth region, measured according to JIS K7210-1:2014 at a temperature of 190°C and a load of 2.16 kg, is 0.8 g/10 minutes or more.

7. The sealing material sheet for a solar cell module according to claim 6, wherein a difference between a gel fraction of the first region and a gel fraction of the fifth region is 0% or more and 25% or less; and a difference between a gel fraction of the tenth region and the gel fraction of the fifth region is 0% or more and 25% or less.

8. A sealing material sheet for a solar cell module comprising:
a first layer including a first olefin based resin, and a melt mass flow rate measured according to JIS K7210-1:2014 at a temperature of 190°C and a load of 2.16 kg is 0.8 g/10 minutes or more; and
a second layer including a second olefin based resin, and a melt mass flow rate measured according to JIS K7210-1:2014 at a temperature of 190°C and a load of 2.16 kg is 0.4 g/10 minutes or less.

9. The sealing material sheet for a solar cell module according to claim 8, wherein the melt mass flow rate of the first layer is 1.7 g/10 minutes or more.

10. The sealing material sheet for a solar cell module according to claim 8, wherein a melt mass flow rate measured according to JIS K7210-1:2014 at a temperature of 190°C and a load of 2.16 kg is 0.20 g/10 minutes or more and 0.80 g/10 minutes or less.

11. The sealing material sheet for a solar cell module according to claim 8, wherein a gel fraction of the first layer, and a gel fraction of the second layer are 25% or less.

12. The sealing material sheet for a solar cell module according to claim 8, wherein a difference between a gel fraction of the first layer and a gel fraction of the second layer is 0% or more and 25% or less.

13. A sealing material sheet for a solar cell module comprising a first surface and a second surface facing the first surface, and including an olefin based resin, wherein
when each region obtained by equally dividing the sealing material sheet for a solar cell module into 10 regions in a thickness direction is numbered from a first region to a tenth region, in order from a first surface side toward a second surface side,
a melt mass flow rate of the first region, measured according to JIS K7210-1:2014 at a temperature of 190°C and a load of 2.16 kg, is 0.8 g/10 minutes or more; and
a melt mass flow rate of the tenth region, measured according to JIS K7210-1:2014 at a temperature of 190°C and a load of 2.16 kg, is 0.4 g/10 minutes or less.

14. The sealing material sheet for a solar cell module according to claim 13, wherein a difference between a gel fraction of the first region and a gel fraction of the tenth region is 0% or more and 25% or less.

15. A solar cell module comprising a solar cell; and the sealing material sheet for a solar cell module according to any one of claim 1 to claim 14.

16. The solar cell module according to claim 15, wherein the solar cell is a perovskite solar cell.

17. A method for producing a solar cell module, the method comprising a lamination step of heating and pressurizing a stacked body including a solar cell and the sealing material sheet for a solar cell module according to any one of claim 1 to claim 14, wherein,
a heating temperature in the lamination step is 60°C or more and 120°C or less.
